# EUROPEAN PATENT SPECIFICATION

(11) **EP 1 998 443 B1**
(45) Date of publication and mention of the grant of the patent: **20.03.2013**
(21) Application number: 07714561.3
(22) Date of filing: 20.02.2007
(51) Int. Cl.: H03H 9/145, H03H 9/02

(54) **ELASTIC WAVE RESONATOR**
RESONATOR FÜR AKUSTISCH-MECHANISCHE SCHWINGUNGEN
RESONATEUR D'ONDE ELASTIQUE

(30) Priority: 17.03.2006 JP 2006073853
(43) Date of publication of application: 03.12.2008
(60) Divisional application: 10170488.0
(73) Proprietor: Murata Manufacturing Co. Ltd., Nagaokakyo-shi, Kyoto 617-8555 (JP)
(72) Inventor: NAKAO, Takeshi, Nagaokakyo-shi, Kyoto 617-8555 (JP); NAKAI, Yasuharu, Nagaokakyo-shi, Kyoto 617-8555 (JP); KADOTA, Michio, Nagaokakyo-shi, Kyoto 617-8555 (JP)
(74) Representative: Schoppe, Fritz
(86) International application number: PCT/JP2007/053058
(87) International publication number: WO 2007/108269

(56) References cited:
- EP-A- 1 744 451
- JP-A- 03 143 112
- JP-A- 07 283 685
- JP-A- 2001 326 557
- JP-A- 2007 019 710
- US-A- 4 684 907
- US-A- 5 767 603
- US-A1- 2001 011 932
- US-A1- 2004 247 153
- INOUE S ET AL: "Low-loss SAW filter on Li2B4O7 using novel-shape apodized structure for 1 GHz RF-ID system" ULTRASONICS SYMPOSIUM, 2005 IEEE ROTTERDAM, THE NETHERLANDS 18-21 SEPT. 2005, PISCATAWAY, NJ, USA,IEEE, vol. 2, 18 September 2005 (2005-09-18), pages 1036-1041, XP010899054 ISBN: 978-0-7803-9382-0

## Description

### Technical Field

The present invention relates to acoustic wave resonators utilizing surface acoustic waves or boundary acoustic waves. More particularly, the invention relates to a one-port acoustic wave resonator in which apodization weighting is applied to IDT electrodes.

### Background Art

Various resonators utilizing surface acoustic waves and boundary acoustic waves have been proposed in the past. For example, Patent Document 1 indicated below discloses a surface acoustic wave resonator illustrated in Fig. 16 and Fig. 17. A surface acoustic wave resonator 501 illustrated in Fig. 16 is a surface acoustic wave resonator utilizing Love waves described in Patent Document 1 as an example of the related art. In this surface acoustic wave resonator 501, an IDT electrode 503 is formed on a piezoelectric substrate 502. The IDT electrode 503 is a normal IDT electrode. The surface acoustic wave resonator 501 utilizes resonance characteristics based on Love waves, and there is a problem in that spurious is generated due to transverse modes.

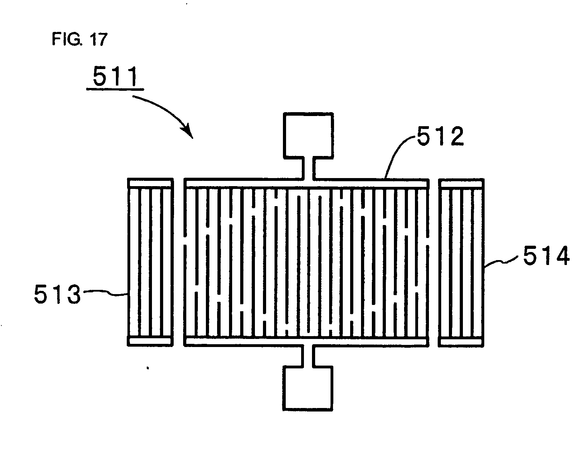

To address this, Patent Document 1 discloses a one-port surface acoustic wave resonator 511 having an electrode structure illustrated in Fig. 17 which can suppress spurious due to transverse modes. In the surface acoustic wave resonator 511, reflectors 513 and 514 are arranged at opposite sides of an IDT electrode 512 in surface acoustic wave propagation directions. As illustrated in the figure, apodization weighting is applied to the IDT electrode 512 such that the cross width is large in a center portion in the surface acoustic wave propagation directions and becomes smaller toward the ends in the surface acoustic wave propagation directions.

In the surface acoustic wave resonator 511, apodization weighting is applied to the IDT electrode 512 in such a manner described above, and, accordingly, response due to transverse modes can be suppressed, realizing satisfactory resonance characteristics.
Patent Document 1: Japanese Patent No. 2645674

### Disclosure of Invention

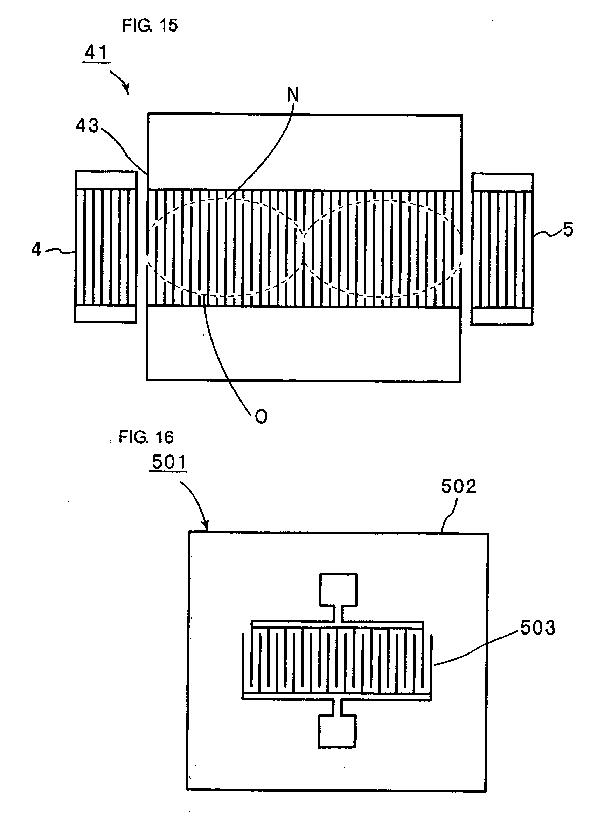

As described in Patent Document 1, in a one-port surface acoustic wave resonator utilizing Love waves, it is possible to suppress transverse-mode spurious by applying apodization weighting to an IDT electrode as described above. However, there is a problem with the above apodization weighting in that the center portion of the IDT electrode 512 has a very large cross width. Specifically, since the above apodization weighting is applied to the IDT electrode 512 illustrated in Fig. 17, the cross width of electrode fingers is very large at the center in the surface acoustic wave propagation directions, compared with the IDT electrode 503 illustrated in Fig. 16, where the areas of the crossing portions of the IDT electrodes are the same. That is, the IDT electrode 512 has a large maximum cross width and thus has long electrode fingers, which results in concentration of power consumption at the center of the IDT electrode 513. This may decrease the power resistance.

In addition, because of the large maximum cross width, the IDT electrode 513 has to have a large dimension in the directions perpendicular to the surface acoustic wave propagation directions.

Further, there is a problem with the above surface acoustic wave resonator 511 in that the Q factor at an anti-resonant frequency is not sufficiently high.

Note that the surface acoustic wave resonator 511 described in Patent Document 1 utilizes Love waves. Such Love waves and Rayleigh waves have relatively low acoustic velocities and are likely to be confined in an IDT, which may result in generation of a transverse mode. When using acoustic waves such as Love waves and Rayleigh waves, which have relatively low acoustic velocities and are not leaky waves, it is difficult to suppress a transverse mode causing spurios by adjusting the crystal orientation of a piezoelectric substrate.

EP-A-1744451, which has been published after the priority date of the present application, discloses a surface acoustic wave apparatus having a configuration by which the spurious effects of higher-order transverse modes are suppressed and a SAW excitation intensity distribution is not changed in the propagation direction. The surface acoustic wave apparatus has at least one interdigital transducer, which is disposed such that a plurality of comb-shape electrodes respectively connected to common electrodes are interleaved, wherein a region where the plurality of comb-shape electrodes are interleaved has a first overlapping region with an overlapping length constant over a whole area along a propagation direction of a surface acoustic wave and a second overlapping region formed on at least one side of the first overlapping region with an overlapping length weighted in the propagation direction of the surface acoustic wave, and wherein an overlapping-length weighting envelope curve in the second overlapping region has at least two changing points in the propagation direction of the surface acoustic wave. This approximates the transverse excitation intensity distribution to the basic transverse mode to constrain coupling to the higher-order transverse modes. The weighting envelope curve in the two regions may be of mirror symmetry or may consist of transversally or longitudinally shifted copies of each other.

US-A-4684907 discloses a single-chip piezoelectric resonator using SH type surface waves and having an interdigital transducer formed on a piezoelectric substrate. The interdigital transducer is designed to have two or more resonance characteristics, for example, by using a pair of thinned-out comb-shaped electrodes with mutually interlocking fingers protruding towards each other. Such an interdigital transducer may be formed also by using a pair of comb-shaped electrodes with the lengths of their mutually pointing fingers varied. A trap circuit with two sufficiently separated trap frequencies and improved attenuation characteristics at these two trap frequencies can be formed by forming two interdigital transducers of the kind described above on a single piezoelectric substrate so as to provide two resonant units each having two resonance characteristics. Alternatively, two piezoelectric resonators of the kind described above may be connected in parallel to provide two resonance characteristics. The attenuation characteristics can be further improved by inserting an inductor connected between the interdigital transducers and/or another inductor between a signal receiving terminal on one of the interdigital transducers and an input terminal through which signal are received by the trap circuit.

US 2001/011932 A1 teaches a surface acoustic wave filter including a piezoelectric substrate, and at least two series arm resonators and at least one parallel arm resonator each constituted by a one-port surface acoustic wave resonator, disposed on the piezoelectric substrate. The at least two series arm resonators and at least one parallel arm resonator are connected to define a ladder-type circuit. Each of the at least two series arm resonators includes an interdigital transducer weighted by apodization, and the apodizations for the at least two series arm resonators are different from each other.

US-A-4684907 discloses a surface wave filter with an input transducer and an output transducer. The input and output transducers have finger weightings such that a finger-overlap profile of the input/output transducer repeats in multiple fashion in the output/input transducer.

In view of the above circumstances associated with the related art described above, an object of the present invention is to provide a surface acoustic wave resonator which utilizes acoustic waves other than leaky acoustic waves, such as Love waves and Rayleigh waves, and is not vulnerable to the effect of spurious caused by a transverse mode or the like and capable of increasing Q at an anti-resonant frequency and realizing satisfactory resonance characteristics.

This object is achieved by an acoustic wave resonator according to claim 1.

There is provided a one-port acoustic wave resonator comprising a piezoelectric substrate and an IDT electrode formed on the piezoelectric substrate. In the acoustic wave resonator, apodization weighting is applied to the IDT electrode such that at least one of a pair of envelopes located at outer sides in directions perpendicular to acoustic wave propagation directions for the apodization weighting includes a plurality of envelope angled portions angled so as to extend from the center toward an outer side of the IDT electrode in a direction perpendicular to the acoustic wave propagation directions, as the envelope angled portions extend in one of the acoustic wave propagation directions.

In the acoustic wave resonator , while the shape of the envelope angled portions is not specifically limited, the envelope angled portions have the shape of a straight-line in another specific aspect of the present invention and have the shape of a curve in yet another aspect of the present invention.

According to an aspect of the present invention, a cross width (overlap length) at at least one end of the IDT electrode in the acoustic wave propagation directions is not more than 50 percent of a maximum cross width.

According to yet another aspect of the present invention, a surface acoustic wave is used as the acoustic wave and a surface acoustic wave resonator is configured on the basis of a surface acoustic wave.

According to yet another aspect of the present invention, a surface acoustic wave other than a leaky surface acoustic wave in which transverse-mode spurious is likely to be generated in a normal IDT, such as a Rayleigh wave or a Love wave, is preferably used as the surface acoustic wave.

### Advantages

In a surface acoustic wave resonator according to the invention, apodization weighting is applied to an IDT electrode such that an overlap length of electrode fingers of the IDT electrode (3) has its maximum value in a plurality of parts of the IDT electrode (3) in surface acoustic wave propagation directions. Thus, loss due to scattering and diffraction at electrode finger end portions can be reduced. This can increase a Q factor at an anti-resonant frequency. In addition, the maximum cross width of the IDT electrode can be reduced, i.e., the aspect ratio can be reduced, compared with a surface acoustic wave resonator to which conventional apodization weighting is applied, when the area of the crossing region is the same. This can mitigate concentration of power at the center of the IDT electrode and thus increase power resistance.

Similarly, an IDT electrode is apodization-weighted such that at least one of a pair of envelopes located at outer sides in directions perpendicular to acoustic wave propagation directions includes a plurality of envelope angled portions angled so as to extend from the center toward an outer side of the IDT electrode in a direction perpendicular to the acoustic wave propagation directions. Therefore, loss due to scattering and diffraction at electrode finger end portions can be reduced and a Q factor at an anti-resonant frequency can be increased.

In addition, since the maximum cross width can be reduced, compared with the case where an IDT electrode to which conventional apodization weighting is applied is used, when the area of the cross width is the same. Thus, power concentration at the center of a long electrode finger can be mitigated and thus the power resistance can be increased.

Specifically, according to embodiments of the invention of the present application, in a one-port acoustic wave resonator in which an IDT electrode is apodization-weighted, not only can ripple due to a transverse mode or the like be reduced, but also a Q factor at an anti-resonant frequency can be increased and the power resistance can be increased.

In the present invention, a Q factor at an anti-resonant frequency can be effectively increased when the aspect ratio r is 0.08 or higher. The upper limit of the aspect ratio r is determined by the chip size, and an excessively large aspect ratio is not desirable since that increases the size of an acoustic wave resonator. However, for the effect of increasing the Q factor at the anti-resonant frequency, it is preferable to set the aspect ratio to not less than 0.08 or, more preferably, not less than 0.12. In addition, the power resistance can be increased when portions to which apodization weighting is applied are consecutively arranged in acoustic wave propagation directions. Thus, when the aspect ratio is set to 0.08 or higher, the power resistance is not markedly decreased. That is, when the aspect ratio is set to 0.08 or higher, it is possible to increase the Q factor at the anti-resonant frequency without markedly reducing the power resistance.

### Brief Description of the Drawings

Fig. 1(a) is a schematic plan view illustrating electrode fingers of a surface acoustic wave resonator according to a first embodiment of the present invention, and Fig. 1(b) is a schematic elevational cross-sectional view of the surface acoustic wave resonator.
Fig. 2 is a diagram illustrating the relationship between the aspect ratio and the Q factor at an anti-resonant frequency, in surface acoustic wave resonators of the first embodiment and a modification example, and surface acoustic wave resonators of a first comparative example and a second comparative example.
Fig. 3 is a diagram illustrating power resistance of surface acoustic wave resonators of the first embodiment and a related-art example.
Fig. 4(a) is a plan view schematically illustrating a normal IDT electrode, Fig. 4(b) is a schematic plan view illustrating a normal IDT electrode obtained by increasing the aspect ratio of the IDT electrode illustrated in Fig. 4(a), and Fig. 4(c) is a schematic plan view illustrating a conventional IDT electrode to which apodization weighting is applied for improving transverse-mode ripple in the IDT electrode illustrated in Fig. 4(b)
Fig. 5 is a schematic plan view illustrating an electrode structure of a conventional surface acoustic wave resonator prepared for comparison with the first embodiment.
Fig. 6 is a diagram illustrating resonance characteristics of a surface acoustic wave resonator having a normal IDT electrode.
Fig. 7 is a diagram illustrating resonance characteristics of a related-art surface acoustic wave resonator having an aspect ratio of 0.06, to which apodization weighting is applied to provide a crossing region having one substantially complete rhombic shape.
Fig. 8 is a diagram illustrating resonance characteristics of a related-art surface acoustic wave resonator having an aspect ratio of 0.14, to which apodization weighting is applied to provide a crossing region having one substantially complete rhombic shape.
Fig. 9 is a diagram illustrating resonance characteristics of a related-art surface acoustic wave resonator having an aspect ratio of 0.25, to which apodization weighting is applied to provide a crossing region having one substantially complete rhombic shape.
Fig. 10 is a diagram illustrating resonance characteristic of the surface acoustic wave resonator of the first embodiment of which the cross width at opposite ends in surface acoustic wave propagation directions is 20 percent of the maximum cross width and of which the aspect ratio is 0.06.
Fig. 11 is a diagram illustrating resonance characteristic of the surface acoustic wave resonator of the first embodiment of which the cross width at opposite ends in surface acoustic wave propagation directions is 20 percent of the maximum cross width and of which the aspect ratio is 0.14.
Fig. 12 is a diagram illustrating resonance characteristic of the surface acoustic wave resonator of the first embodiment of which the cross width at opposite ends in surface acoustic wave propagation directions is 20 percent of the maximum cross width and of which the aspect ratio is 0.25.
Fig. 13 is a schematic plan view illustrating an example of a modification of the first embodiment to which apodization weighting is applied such that two rhombic crossing regions exhibit complete rhombic shapes and the cross width at the ends in surface acoustic wave propagation directions is zero.
Fig. 14 is a schematic plan view for illustrating another example of an IDT electrode of a surface acoustic wave resonator of the present invention.
Fig. 15 is a schematic plan view for illustrating another example of an IDT electrode of a surface acoustic wave resonator of the present invention.
Fig. 16 is a schematic plan view illustrating an example of an electrode structure of a related-art surface acoustic wave resonator.
Fig. 17 is a schematic plan view illustrating another example of an electrode structure of a related-art surface acoustic wave resonator.

### Reference Numerals

- 1: surface acoustic wave resonator
- 2: piezoelectric substrate
- 3: IDT electrode
- 4,5: reflectors
- 21: surface acoustic wave resonator
- 23: IDT electrode
- 31: surface acoustic wave resonator
- 33: IDT electrode
- 41: surface acoustic wave resonator
- 43: IDT electrode
- 51: surface acoustic wave resonator
- 53: IDT electrode

### Best Mode for Carrying Out the Invention

The present invention will become apparent from the following detailed description of embodiments thereof with reference to the drawings.

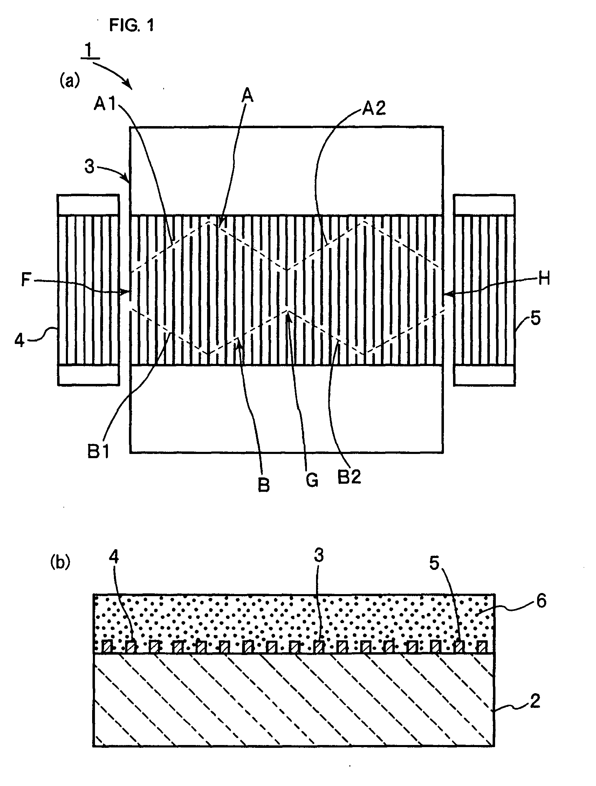

Fig. 1(a) is a schematic plan view illustrating an electrode structure of a surface acoustic wave resonator according to a first embodiment of the present invention and Fig. 1(b) is a schematic elevational cross-sectional view of the surface acoustic wave resonator. A surface acoustic wave resonator 1 has a piezoelectric substrate 2. In the present embodiment, the piezoelectric substrate 2 is formed of a 126-degree Y-cut, X-propagating LiNbO₃ substrate. Note that the piezoelectric substrate 2 may be composed of a LiNbO₃ substrate having another crystal orientation or of another piezoelectric single crystal such as LiTaO₃. In addition, the piezoelectric substrate 2 may be composed of piezoelectric ceramics. Further, the piezoelectric substrate 2 may have a structure in which a piezoelectric film is laminated on an insulating material.

An IDT electrode 3 is formed on the piezoelectric substrate 2. Reflectors 4 and 5 are disposed at opposite sides of the IDT electrode 3 in the surface acoustic wave propagation directions.

As illustrated in Fig. 1(a), the IDT electrode 3 has a pair of comb-shaped electrodes and is apodization-weighted such that a plurality of maximum values of cross width are present in the surface acoustic wave propagation directions. In other words, the IDT electrode 3 is apodization-weighted and has a first envelope A and a second envelope B on outer sides in the directions perpendicular to the surface acoustic wave propagation directions. Note that an envelope is a virtual line formed by connecting the ends of a plurality of electrode fingers connected to one potential. In the present embodiment, the envelopes A and B have envelope angled portions A1, A2, B1, and B2 which are angled so as to extend from the center toward the outer sides of the IDT electrode 3 in the directions perpendicular to the surface acoustic wave propagation directions, as they extend in one of the surface acoustic wave propagation directions.

Specifically, in the envelope angled portion A1, the envelope A is angled from the center to the outer side in a direction perpendicular to the surface acoustic wave propagation directions of the IDT electrode as it extends from the end of the IDT electrode 3 at the reflector 4 side toward the reflector 5 side. The envelope angled portion A2 is similarly formed. Thus, the envelope A has a plurality of envelope angled portions.

In the present embodiment, the envelope B also has a plurality of envelope angled portions B1 and B2.

In the surface acoustic wave resonator 1 of the first embodiment, a crossing region enclosed by the envelopes A and B is formed to have two rhombic regions. Note that as illustrated in Fig. 1(a), two sides of each of the rhombuses are not fully brought into contact with each other at tips of the rhombuses, and apodization weighting is applied such that two of such generally rhombic shapes are consecutively arranged. More specifically, at parts indicated by arrows F, G, and H in Fig. 1(a), i.e., one of the rhombic regions, the cross width is not zero at the opposite ends in the surface acoustic wave propagation directions and is 20 percent of the maximum cross width. The cross width at the ends may be small to the extent that transverse-mode spurious can be reduced. Preferably, the cross width may not be more than 50 percent of the maximum cross width, and more preferably, may not be more than 25 percent of the maximum cross width.

In the reflectors 4 and 5, a plurality of electrode fingers extending in the directions perpendicular to the surface acoustic wave propagation directions are shortcircuited at both ends.

In the present embodiment, the IDT electrode 3 and the reflectors 4 and 5 are each formed of a Cu film having a thickness of 0.05 λ when the wavelength of a surface acoustic wave is λ. Note that the IDT electrode 3 and the reflectors 4 and 5 may be formed of another metal such as A1 and Ag or an alloy. In addition, the IDT electrode 3 and the reflectors 4 and 5 may be formed of a multilayer metal film composed of a laminate of a plurality of metal films.

In the present embodiment, an insulating film 6 for improving temperature characteristics is laminated so as to cover the IDT electrode 3. In the present embodiment, the insulating film 6 is formed of an SiO₂ film having a thickness of 0.27 λ. The SiO₂ film has a positive frequency temperature coefficient, while the LiNbO₃ substrate has a negative frequency temperature coefficient. Thus, by laminating the insulating film 6 formed of an SiO₂ film, a temperature change due to the frequency of the surface acoustic wave resonator 1 can be suppressed, and the temperature characteristics are improved.

Note that the insulating film 6 for improving temperature characteristics may not be necessarily be provided. In addition, the insulating film 6 for improving temperature characteristics may be formed of an insulating material other than SiO₂.

A feature of the surface acoustic wave resonator 1 of the present embodiment is that the IDT electrode 3 is apodization weighted as described above. This increases the Q factor at an anti-resonant frequency and also increases the power resistance. In addition, the degree of freedom in designing the surface acoustic wave resonator 1 can be increased. This will be described in more detail below.

As illustrated in Fig. 1(a), the IDT electrode 3 is apodization-weighted such that the crossing region enclosed by the envelopes A and B exhibits the shape of two rhombuses arranged in the surface acoustic wave propagation directions. Thus, the maximum value of the cross width is present in two parts in the surface acoustic wave propagation directions. In other words, in at least one of the envelopes A and B, the envelope angled portions A1 and A2 or B1 and B2 are provided in two parts, respectively.

Such weighting can improve the Q factor at an anti-resonant frequency, for the following reasons.

A surface acoustic wave is scattered and diffracted by another surface wave or bulk wave at a leading end of an electrode finger or in a gap present at the outside of the leading end, which results in loss. Thus, the Q factor at an anti-resonant frequency may be deteriorated for this reason. On the other hand, in the present embodiment, this loss can be suppressed since the envelopes A and B described above have a plurality of envelope angled portions A1, A2, B1 and B2. It is considered that this reduces the diffraction loss and thus the Q factor at an anti-resonant frequency is increased.

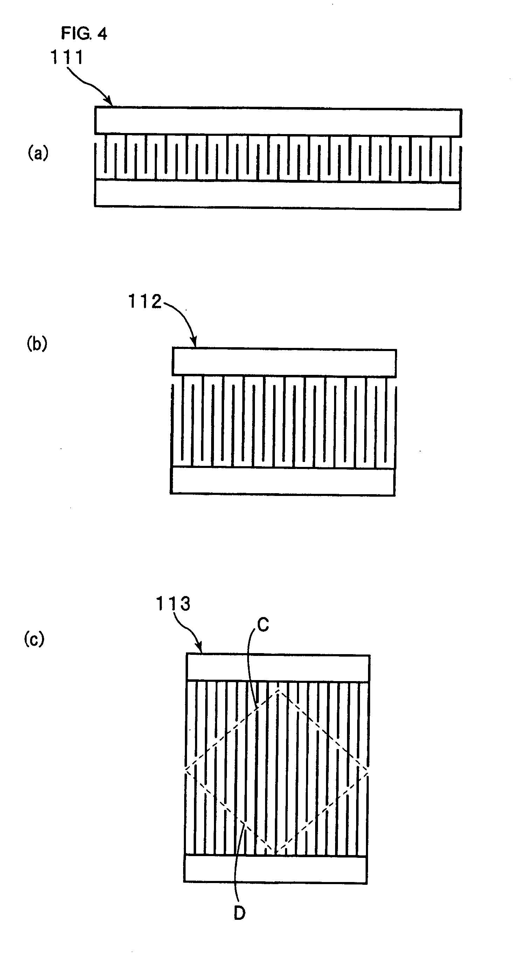

This will be more specifically described using Figs. 4(a) to 4(c) as examples. In order to increase an anti-resonant frequency Q-factor when an IDT electrode 111 has an aspect ratio of 0.06 and a cross width of 10 λ, an IDT electrode 112 having a cross width of 20 λ and an aspect ratio of 0.25 may be provided, as illustrated in Fig. 4(b). Then, in order to suppress transverse-mode spurious, weighting is applied to the IDT electrode such that the crossing region enclosed by envelopes has a rhombic shape, as illustrated in Fig. 4(c). At this time, when the aspect ratio of 0.25 is not changed, the IDT electrode has a very large cross width of 40 λ. Although this improves the anti-resonant Q factor, the cross width is very large, which significantly decreases the degree of freedom in design and decreases the power resistance.

On the other hand, in the embodiment described above, in order to suppress transverse-mode spurious while having the same area S of a crossing area as the IDT electrode 112, weighting is applied such that a crossing region with two rhombic portions is provided. This can not only increase the anti-resonant frequency Q and reduce the transverse-mode spurious but also can reduce the aspect ratio and enhance the power resistance. Since the aspect ratio can be reduced, the size of a chip in the directions perpendicular to the surface acoustic wave propagation directions can be reduced, which can also increase the degree of freedom in design.

Now, the meaning of an aspect ratio r will be described with reference to Figs. 4(a) to 4(c). The aspect ratio is expressed as (normalized cross width)/(number of pairs). The normalized cross width refers to a (= L/λ), in which a cross width L is normalized by a wavelength λ of a surface wave. As illustrated in Fig. 4(a), the normal IDT electrode 111, to which apodization weighting is not applied, has a constant cross width. Thus, the aspect ratio r = (cross width)/(number of pairs) can be immediately obtained when the cross width and the number of pairs of electrode fingers are given. On the other hand, in an IDT electrode 113, to which apodization weighting is applied, the cross width is changed along the surface acoustic wave propagation directions. Specifically, in the IDT electrode 113, the cross width is largest at the center of the IDT electrode 113 and this cross width is the maximum cross width. The cross width becomes smaller from the center toward the outer sides of the IDT electrode 113 in the surface acoustic wave propagation directions. Therefore, it is not possible to immediately obtain the aspect ratio r which is calculated as (cross width)/(number of pairs).

Thus, in the case of the IDT electrode 113, when the area of the crossing region of the IDT electrode 113 is set as S, the equivalent normal IDT electrode 112 having the same area of the crossing region and the same number of pairs of electrode fingers is assumed. In other words, the area S of the crossing region of the IDT electrode 113, i.e., the area of the portion enclosed by envelopes C and D, is set as S. The area of crossing region in the IDT electrode 112 is also S. The numbers of electrode fingers of the IDT electrode 112 and the IDT electrode 113 are both b. Therefore, when a normalized cross width of the electrode fingers of the IDT electrode 112 is a, the aspect ratio r of the IDT electrode 112 is expressed as a/b, and it is assumed that the IDT electrode 113 has an aspect ratio that is expressed as a/b = r.

That is, the aspect ratio of the normal IDT electrode 112 of which the area S of the crossing region is the same as that of the IDT electrode 113 is set as the aspect ratio r of the IDT electrode 113. In this way, the aspect ratio of the normal IDT electrode 112 having the same area S of crossing portion and the same number of pairs of electrode fingers is used as the aspect ratio of the IDT electrode 113. This is because the cross width of the IDT electrode 113 changes along the surface acoustic wave propagation directions and is not constant, as described above.

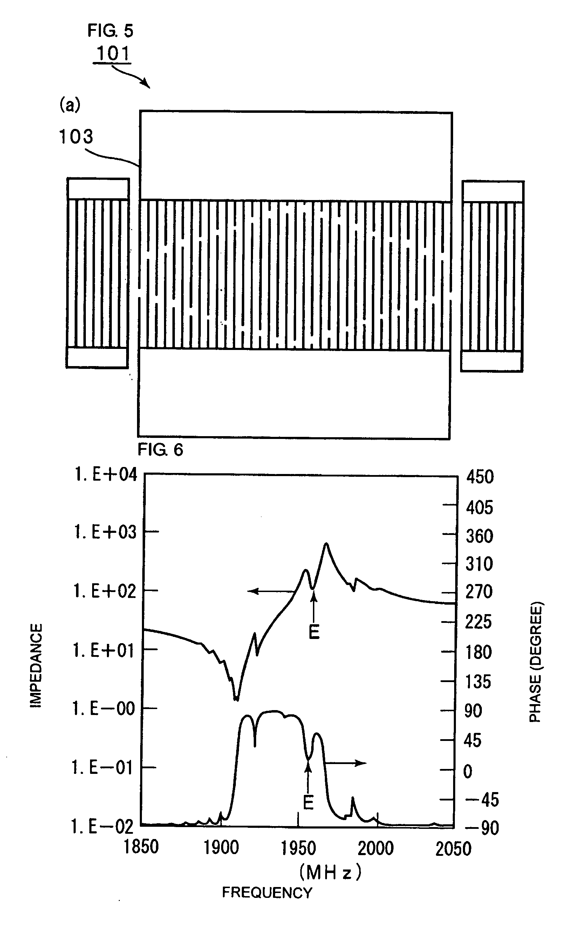

Now, as illustrated in Fig. 5, a conventional surface acoustic wave resonator 101 is prepared as a comparative example of a surface acoustic wave resonator. The surface acoustic wave resonator is configured similarly to the surface acoustic wave resonator 1 of the above embodiment, except that an IDT electrode 103 is apodization-weighted so that the crossing region exhibits one rhombic shape.

Then, the aspect ratios of the surface acoustic wave resonator of the comparative example and the surface acoustic wave resonator of the first embodiment are changed and corresponding Q factors at anti-resonant frequencies were measured.

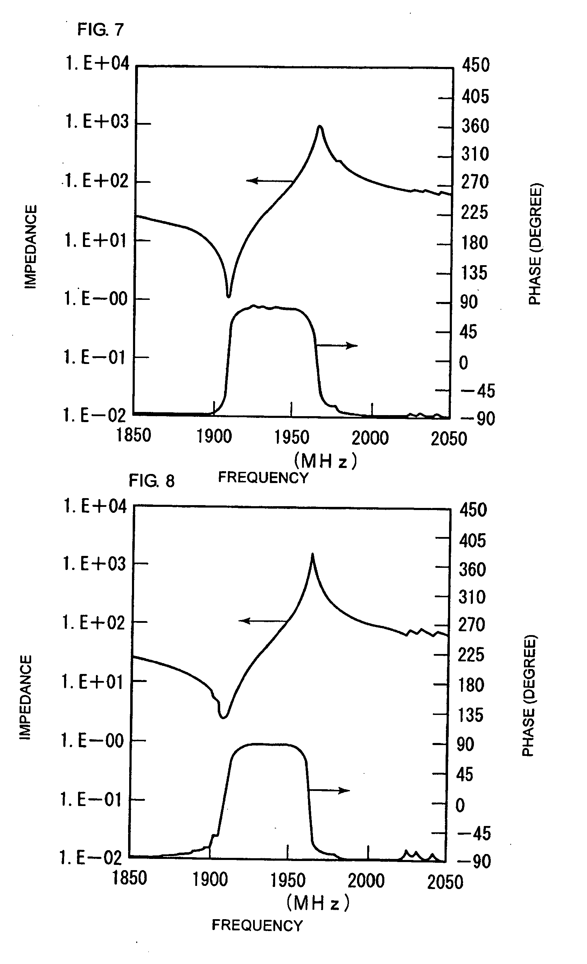

Fig. 6 to Fig. 12 illustrate resonance characteristics obtained by changing the aspect ratios of a surface acoustic wave resonator having a normal IDT electrode, the surface acoustic wave resonator 101 of the comparative example described above, and the surface acoustic wave resonator 1 of the above embodiment. Fig. 6 illustrates resonance characteristics of the surface acoustic wave resonator using the normal IDT electrode having the same area S of the crossing region and the same number of pairs of electrode fingers as the surface acoustic wave resonator of the above embodiment. Fig. 7 to Fig. 9 illustrate resonance characteristics of the surface acoustic wave resonator 101 of the related-art example prepared for comparison, with its aspect ratio r set to 0.06, 0.14, and 0.25, respectively.

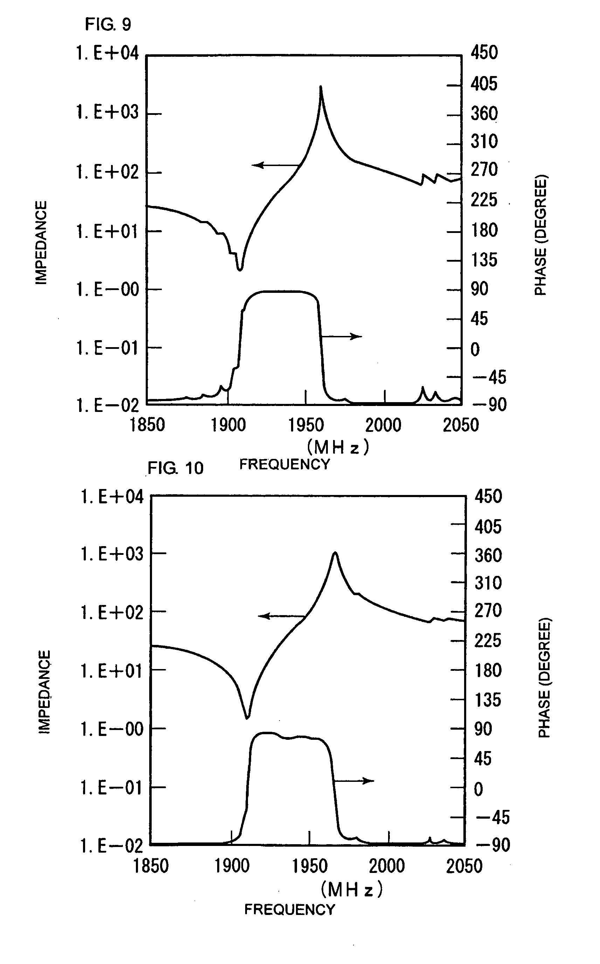

Fig. 10 to Fig. 12 illustrate resonance characteristics of the surface acoustic wave resonator of the first embodiment, with its aspect ratio r set to 0.06, 0.14, and 0.25, respectively.

As illustrated in Fig. 6, in the surface acoustic wave resonator having the normal IDT electrode, large spurious due to a transverse mode is present between a resonant frequency and an anti-resonant frequency, as indicated by an arrow E.

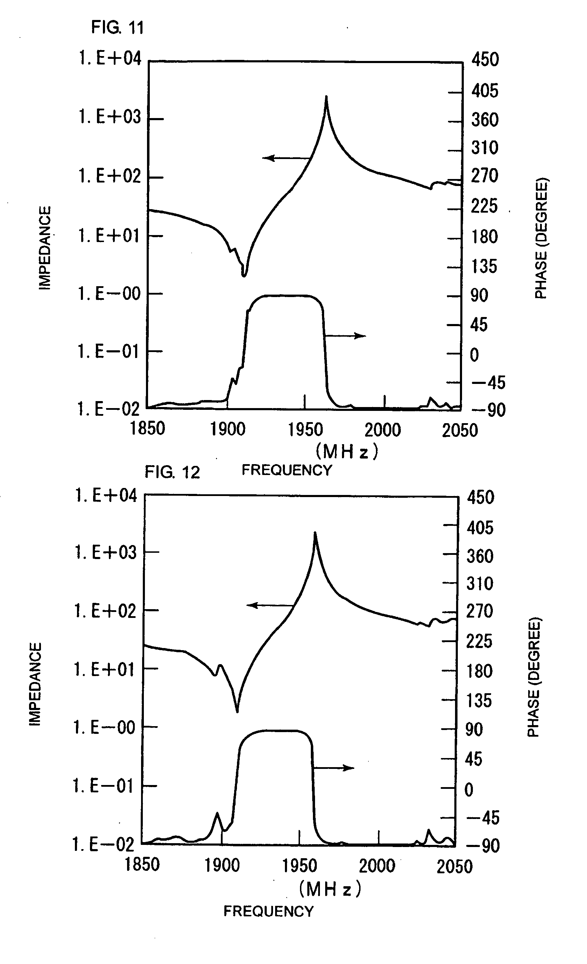

On the other hand, as illustrate in Fig. 7 to Fig. 12, in each of the surface acoustic wave resonator of the above related-art example and the surface acoustic wave resonator of the above embodiment, it can be seen that spurious present between the resonant frequency and the anti-resonant frequency is suppressed. In addition, as is apparent from comparison between Fig. 7 to Fig. 9 and Fig. 10 and Fig. 12 respectively, in the surface acoustic wave resonator of the above embodiment, the peak of the anti-resonant frequency is steep and the Q factor in the anti-resonant frequency is increased compared with the surface acoustic wave resonator of the related-art example, where these surface acoustic wave resonator have the same aspect ratio. That is, according to the surface acoustic wave resonator 1 of the present embodiment, the Q factor at the anti-resonant frequency can be increased as compared to the related-art example, when the aspect ratios thereof are the same. For example, the resonance characteristic illustrated in Fig. 9 corresponds to the aspect ratio of 0.25 in the related-art example. It can be seen the resonance characteristic near the anti-resonant frequency is equivalent to the resonance characteristic of the surface acoustic wave resonator of the first embodiment with the aspect ratio of 0.14 illustrated in Fig. 11.

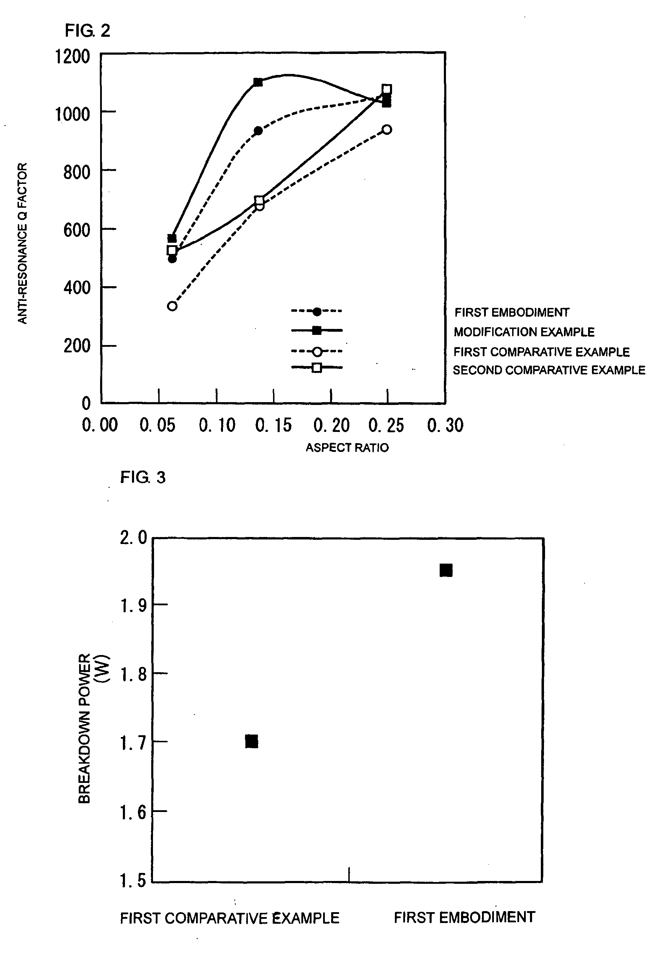

Fig. 2 illustrates the relationship between the aspect ratio defined as described above and the Q factor at the anti-resonant frequency. Fig. 2 shows the results corresponding to the first embodiment, an example of a modification of the first embodiment described below, the surface acoustic wave resonator 101 of the first comparative example illustrated in Fig. 5, and a surface acoustic wave resonator of the second comparative example which is a modification example of the surface acoustic wave resonator 101. As is apparent from comparison between the results corresponding to the first embodiment and the surface acoustic wave resonator of the first comparative example illustrated in Fig. 2, according to the first embodiment, compared with the equivalent surface acoustic wave resonator of the first comparative example, the Q factor at the anti-resonant frequency can be increased regardless of the aspect ratio. In addition, as is apparent from Fig. 2, the Q factor at the anti-resonant frequency increases with increasing aspect ratio.

Thus, according to the present embodiment, the Q factor at the anti-resonant frequency can be increased compared with the related-art surface acoustic wave resonator 101 prepared for comparison, if the same aspect ratio is given. Thus, according to the present embodiment, the aspect ratio can be reduced to have the same Q factor at an anti-resonant frequency as the conventional surface acoustic wave resonator 101. For example, it can be seen from Fig. 2 that to set the Q factor at the anti-resonant frequency to 1000, the aspect ratio of the conventional surface acoustic wave resonator is about 0.25, while the aspect ratio can be as small as 0.15 according to the present embodiment, indicating that the cross width can be reduced by about 20 percent. Accordingly, since the aspect ratio r can be reduced, the length of the longest electrode finger can be reduced, which increases the power resistance.

Fig. 3 is a diagram illustrating the breakdown power of the surface acoustic wave resonator of the first embodiment and that of the conventional surface acoustic wave resonator prepared as the first comparative example. The breakdown power (W) was obtained by measuring the breakdown power of latter filters configured using a plurality of surface acoustic wave resonators 1 and 101, in the following manner. Each of the surface acoustic wave resonators 1 and the surface acoustic wave resonators 101 was used as a parallel arm resonator of a ladder filter having three series arm resonators and two parallel arm resonators. The other resonators were formed using conventional rhombic-weighted resonators.

Then, power was applied to the input of each of the ladder filters obtained as described above, and the power at which IDT electrodes of the parallel arm resonators were broken was set as the breakdown power.

As is apparent from Fig. 3, according to the first embodiment, compared with the equivalent related-art surface acoustic wave resonator 101, the breakdown power can be increased from 1.7 W to 1.95 W, indicating that the power resistance can be increased by about 15 percent.

The power resistance can be increased since the maximum cross width can be decrease when the area S of a crossing region is the same. Specifically, when the area S of the crossing region of the surface acoustic wave resonator 1 is equal to the area S of the crossing region of the surface acoustic wave resonator 101, the maximum cross width of the surface acoustic wave resonator 1, i.e., the cross width of a part at which the longest electrode finger is located, is actually smaller than the maximum cross width at the center of the surface acoustic wave resonator illustrated in Fig. 5. On the other hand, applied power is prone to concentrate on the center of the longest electrode finger, i.e., the center of the electrode finger corresponding to the maximum cross width. Thus, in the surface acoustic wave resonator 101, since the length of the longest electrode finger is large, breakdown is likely to occur due to the power concentration.

On the other hand, in the surface acoustic wave resonator 1 of the above embodiment, not only is the length of the longest electrode finger small, but also the longest electrode fingers are disposed at two parts in accordance with apodization weighting that forms the shape of two rhombuses, and thus the concentration of power consumption is dispersed. Therefore, breakdown of electrode fingers is not likely to occur, and the power resistance is effectively increased.

It was found by the present inventor that even when apodization weighting is applied such that crossing regions enclosed by two rhombuses are provided, the effect of reduction of spurious due to transverse modes can be sufficiently achieved, as indicated in Fig. 11 and Fig. 12.

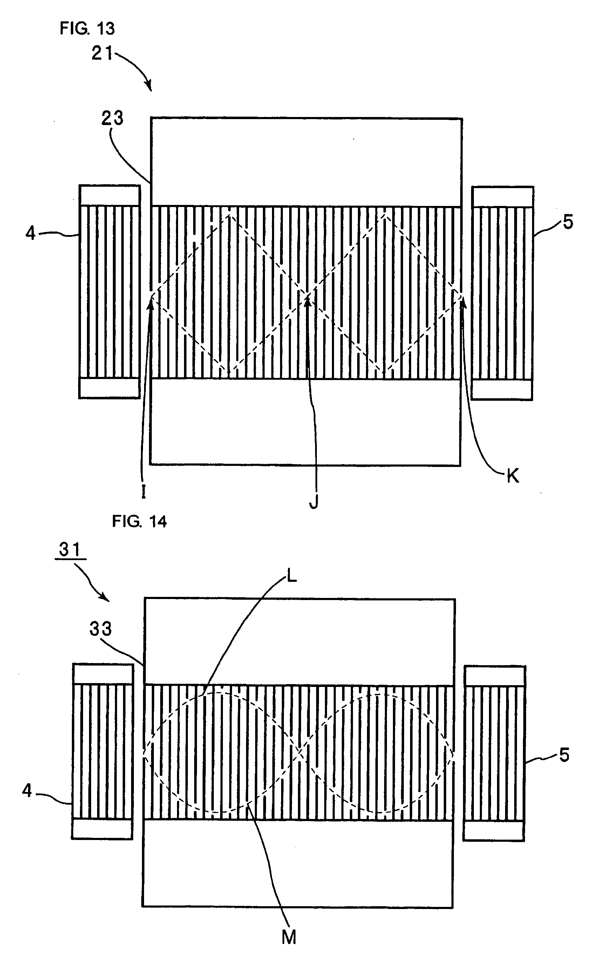

Fig. 13 is a schematic plan view illustrating an electrode structure of a surface acoustic wave resonator according to an example of a modification of the first embodiment of the present invention.

In a surface acoustic wave resonator 21 of the modification example illustrated in Fig. 13, an IDT electrode 23 is substantially similar to the surface acoustic wave resonator 1 in that two rhombic-shaped crossing regions are arranged in the surface acoustic wave propagation directions. However, in this surface acoustic wave resonator 21, the cross width at the opposite ends of the individual rhombuses in the surface acoustic wave propagation directions is substantially zero. Specifically, the cross width at parts indicated by arrows I, J, and K is substantially zero. In this way, when a plurality of rhombic-shaped crossing regions are consecutively arranged in the surface acoustic wave propagation directions, the cross width at opposite ends in the surface acoustic wave propagation directions may be set to zero.

Fig. 2 also illustrates the relationship between the aspect ratio and the Q factor at an anti-resonant frequency of the surface acoustic wave resonator 21 of the modification example which is configured similarly to the first embodiment except that the weighting is applied as described above. For comparison, a surface acoustic wave resonator having one rhombic-shaped crossing region and having a cross width at the opposite ends in the surface acoustic wave propagation directions of substantially zero was also prepared. Specifically, a surface acoustic wave resonator of the second comparative example to which apodization weighting is applied so that the shape of a substantially complete rhombus is provided was prepared, and the aspect ratio and the Q factor at the anti-resonant frequency were measured. The result of the measurement is also indicated in Fig. 2.

As is apparent from Fig. 2, with a surface acoustic wave resonator having a rhombic-shaped crossing region, even when weighting is applied so that the cross width is substantially zero at the opposite ends in the surface acoustic wave propagation directions, the Q factor at the anti-resonant frequency can be effectively increased by arranging a plurality of crossing regions in the surface acoustic wave propagation directions.

In addition, as is apparent from comparison between the result of the first embodiment and that of the above modification example, by setting the cross width of the crossing region to zero at opposite ends in the surface acoustic wave propagation directions, i.e., setting the crossing region to have the shape of a complete rhombus, as in the case of the above modification example, the Q factor at the anti-resonant frequency can be further effectively increased compared with the first embodiment.

Further, as is apparent from Fig. 2, by setting the aspect ratio to 0.08 or higher in any of the first embodiment or the above modification example, the Q factor at the anti-resonant frequency can be effectively increased compared with the related-art example having the same aspect ratio. Therefore, the aspect ratio r is preferably set to be 0.08 or higher. It is more preferable that the aspect ratio is set to 0.12 or higher. This makes it possible to achieve a Q factor which cannot be provided by an equivalent related-art example. Thus, more preferably, the aspect ratio is set to 0.12 or higher.

In the first embodiment and the modification example, each of the envelopes A and B has the shape of a straight line, and thus a plurality of rhombic-shaped crossing regions are arranged in surface acoustic wave propagation directions. However, the envelopes may also be a curve shape. In a surface acoustic wave resonator 31 which is an modification example illustrated in Fig. 14, an IDT electrode 33 is apodization-weighted so as to have cosine-curve-shaped envelopes L and M. Also in this case, two crossing region enclosed by the envelopes L and M are arranged along the surface acoustic wave propagation directions.

Moreover, in a surface acoustic wave resonator 41 illustrated in Fig. 15, in apodization weighting applied to an IDT electrode 43, each of envelopes N and O has a curve shape so that two crossing regions arranged in the surface acoustic wave propagation directions have oval shapes.

In this way, in the present invention, in apodization weighting applied to an IDT electrode, an envelope may have the shape of a straight-line or a curve.

In addition, in each of the above embodiment and the modification examples, the case where a surface acoustic wave resonator utilizing Rayleigh waves is described. However, the surface acoustic wave resonator may utilize another type of non-leaky waves such as Love waves. In addition, the surface acoustic wave resonator may be a one-port surface acoustic wave resonator utilizing not only surface acoustic waves but also boundary acoustic waves.

Note that in the present invention, in weighting to be applied to an IDT electrode, the shape of an envelope angled portion and the planar shape of a crossing region are not limited to any specific shape, as long as apodization weighting is applied such that a plurality of maximum values of the cross width are present in surface acoustic wave propagation directions, or as long as at least one of a pair of envelopes includes a plurality of envelope angled portions angled from the center toward outer sides of the IDT electrode in the directions perpendicular to the surface acoustic wave propagation directions.

## Claims

1. An acoustic wave resonator (1), the acoustic wave resonator being a one-port acoustic wave resonator, comprising:
a piezoelectric substrate (2); and
an IDT electrode (3) formed on the piezoelectric substrate (2),
wherein apodization weighting is applied to the IDT electrode (3) such that an overlap length of electrode fingers of the IDT electrode (3) has its maximum value in a plurality of parts of the IDT electrode (3) in acoustic wave propagation directions,
wherein an aspect ratio r expressed as r=a/b is not less than 0.08, wherein b is a number of pairs of electrode fingers of the IDT electrode, and a · λ is an overlap length of an equivalent unapodized IDT electrode having the same area in which the electrode fingers overlap and the same number of pairs of electrode fingers as the IDT electrode, λ being a wavelength of an acoustic wave.

2. The acoustic wave resonator according to claim 1,
Wherein an overlap length of electrode fingers at at least one end of the IDT electrode in the acoustic wave propagation directions is not more than 50 percent of a maximum overlap length of electrode fingers.

3. The acoustic wave resonator according to any one of claims 1 or 2,
wherein a surface acoustic wave is used as the acoustic wave and a surface acoustic wave resonator is configured on the basis of a surface acoustic wave.

4. The acoustic wave resonator according to claim 3,
wherein a Rayleigh wave or a Love wave is used as the surface acoustic wave.

## Patentansprüche

1. Ein Akustikwellenresonator (1), wobei der Akustikwellenresonator ein Ein-Tor-Akustikwellenresonator ist, der folgende Merkmale aufweist:
ein piezoelektrisches Substrat (2); und
eine IDT-Elektrode (3), die auf dem piezoelektrischen Substrat (2) gebildet ist,
wobei eine Apodisationsgewichtung derart auf die IDT-Elektrode (3) angewendet wird, dass eine Überlappungslänge von Elektrodenfingern der IDT-Elektrode (3) ihren maximalen Wert in einer Mehrzahl von Teilen der IDT-Elektrode (3) in Ausbreitungsrichtungen einer akustischen Welle aufweist,
wobei ein Aspektverhältnis r, ausgedrückt als r=a/b, nicht kleiner als 0,08 ist, wobei b eine Anzahl von Paaren von Elektrodenfingern der IDT-Elektrode ist und a · λ eine Überlappungslänge einer äquivalenten nicht-apodisierten IDT-Elektrode mit der gleichen Fläche, in der sich die Elektrodenfinger überlappen, sowie der gleichen Anzahl von Paaren von Elektrodenfingern wie die IDT-Elektrode ist, wobei λ eine Wellenlänge einer akustischen Welle ist.

2. Der Akustikwellenresonator gemäß Anspruch 1,
bei dem eine Überlappungslänge von Elektrodenfingern an zumindest einem Ende der IDT-Elektrode in den Ausbreitungsrichtungen einer akustischen Welle nicht mehr beträgt als 50 Prozent einer maximalen Überlappungslänge von Elektrodenfingern.

3. Der Akustikwellenresonator gemäß einem der Ansprüche 1 oder 2,
bei dem eine akustische Oberflächenwelle als die akustische Welle verwendet wird und ein Oberflächenwellenresonator auf der Basis einer akustischen Oberflächenwelle ausgebildet ist.

4. Der Akustikwellenresonator gemäß Anspruch 3,
bei dem eine Rayleigh-Welle oder eine Love-Welle als die akustische Oberflächenwelle verwendet wird.

## Revendications

1. Résonateur à ondes acoustiques (1), qui est un résonateur à ondes acoustiques à un port, qui comprend :
un substrat piézoélectrique (2) ; et
une électrode IDT (3) formée sur ledit substrat piézoélectrique (2),
dans lequel une pondération d'apodisation est appliquée à ladite électrode IDT (3) afin qu'une longueur de chevauchement des tiges d'électrode de ladite électrode IDT (3) présente sa valeur maximale dans une pluralité de parties de ladite électrode IDT (3) dans les directions de propagation des ondes acoustiques,
dans lequel un rapport d'aspect r exprimé par r=a/b est non inférieur à 0,08, b étant un nombre de paires de tiges d'électrode de ladite électrode IDT, et a * λ étant une longueur de chevauchement d'une électrode IDT non apodisée équivalente ayant la même surface dans laquelle les tiges d'électrode se chevauchent, et le même nombre de paires de tiges d'électrode que ladite électrode IDT, λ étant une longueur d'onde d'une onde acoustique.

2. Résonateur à ondes acoustiques selon la revendication 1,
dans lequel une longueur de chevauchement des tiges d'électrode au niveau d'au moins une extrémité de ladite électrode IDT dans les directions de propagation des ondes acoustiques est non supérieure à 50 pourcents d'une longueur de chevauchement maximale des tiges d'électrode.

3. Résonateur à ondes acoustiques selon l'une quelconque des revendications 1 ou 2,
dans lequel une onde acoustique de surface est utilisée comme onde acoustique, et un résonateur à ondes acoustiques de surface est configuré sur la base d'une onde acoustique de surface.

4. Résonateur à ondes acoustiques selon la revendication 3,
dans lequel une onde de Rayleigh ou une onde de Love est utilisée comme onde acoustique de surface.
